Europäisches Patentamt

European Patent Office

Office européen des brevets

(19)

(11) Veröffentlichungsnummer: **0 363 679**

**A2**

(12) # EUROPÄISCHE PATENTANMELDUNG

(21) Anmeldenummer: **89117182.9**

(22) Anmeldetag: **16.09.89**

(51) Int. Cl.5: **H01L 23/495 , H01L 21/48**

(30) Priorität: **10.10.88 DE 3834361**

(43) Veröffentlichungstag der Anmeldung:
**18.04.90 Patentblatt 90/16**

(84) Benannte Vertragsstaaten:
**AT BE CH DE ES FR GB GR IT LI NL SE**

(71) Anmelder: **LSI LOGIC PRODUCTS GMBH**
**Hansestrasse 48**
**D-3300 Braunschweig(DE)**

(72) Erfinder: **Westerkamp, Hugo**
**Quellenweg 1 a**
**D-3340 Wolfenbüttel-Salzdahlum(DE)**

(74) Vertreter: **Lins, Edgar, Dipl.-Phys. et al**
**Patentanwälte Gramm + Lins**
**Theodor-Heuss-Strasse 2**
**D-3300 Braunschweig(DE)**

(54) **Anschlussrahmen für eine Vielzahl von Anschlüssen.**

(57) Ein Anschlußrahmen für eine Vielzahl von auf engstem Raum angeordneten Anschlüssen (4), insbesondere von hochintegrierten Halbleiterchips (5), bestehend aus metallischen Leitern (1), die von äußeren großen Abständen (2) zu den Anschlüssen (4) hin aufeinander zulaufen und mit den Anschlüssen verbindbar sind, erlaubt eine hohe Anschlußzahl mit einem geringen Abstandsmaß der Leiter (1) an ihren inneren Enden, wenn die metallischen Leiter (1) im äußeren Bereich im herkömmlichen Fertigungsverfahren und an ihren zu den Anschlüssen (4) zeigenden Enden durch Laserschneiden von einheitlich metallischem Material hergestellt sind.

Fig. 2

## Anschlußrahmen für eine Vielzahl von Anschlüssen

Die Erfindung betrifft einen Anschlußrahmen für eine Vielzahl von auf engstem Raum angeordneten Anschlüssen, insbesondere von hochintegrieten Halbleiterchips, bestehend aus metallischen Leitern, die von äußeren großen Abständen zu den Anschlüssen hin aufeinander zulaufen und mit den Anschlüssen verbindbar sind.

Derartige Anschlußrahmen (lead frames) werden insbesondere zur Kontaktierung von einem oder mehreren hochintegrierten Halbleiterchips verwendet. Die Halbleiterchips tragen an ihrem äußeren Rand Anschlußfelder auf, die nach heutiger Technik quadratisch sind und eine Kantenlänge von 90 μ - 120 μ sowie einen Abstand von Feld zu Feld von mindestens 30 μ haben. Der Kontakt zu den inneren Enden der Leiter der Anschlußrahmen wird üblicherweise durch Bonddrähtchen mit einem Durchmesser von 25μ-30μ hergestellt.

Die Anschlußrahmen werden üblicherweise mit äußeren Randstücken produziert, die nach Positionierung des Anschlußrahmens ab- bzw. aufgetrennt werden, so daß die einzelnen Leiter des Anschlußrahmens elektrisch nicht mehr miteinander verbunden sind.

Zu Herstellung der Anschlußrahmen steht als preiswertestes Verfahren die Stanztechnik zur Verfügung. Aufgrund der relativ hohen Werkzeugkosten ist dieses Herstellungsverfahren nicht flexibel. Für höhere Anschlußzahlen nimmt die Komplexität der Werkzeuge zu, wodurch sich die Genauigkeitsprobleme vervielfachen. In dieser Technik werden daher Anschlußzahlen bis zu ca. 120 realisiert.

Ein weiteres bekanntes Verfahren zur Herstellung der Anschlußrahmen ist die Ätztechnik, durch die aus einer gleichmäßigen metallischen Fläche die gewünschten Strukturen herausgeätzt werden, so daß die gewünschten metallischen Leiter stehen bleiben. Der Ätzvorgang kann in üblicher Weise durch fotografische Abdeckverfahren gesteuert werden. Dieses Verfahren zeichnet sich zwar durch niedrige Werkzeugkosten und durch eine hohe Flexibilität aus, führt aber zu relativ hohen Produktionskosten, weil Automatisierungen noch nicht in wirtschaftlich bedeutsamem Maße gelungen sind.

Beide Verfahren führen zu einer minimalen Anschlußbreite sowie einem minimalen lichten Abstand zwischen den Anschlüssen der Leiter in der Größenördnung der Materialstärke, die beispielsweise 150 μ beträgt. Die minimale Anschlußbreite von 150 μ und der minimale Abstand von ebenfalls 150 μ führt zu einem Anschlußraster von 300 μ. Aufgrund der begrenzten Länge der Bonddrähtchen wird nach den bekannten Techniken eine Anschlußzahl von bis zu 160 bei einem quadratischen Gehäuse von 28 mm Kantenlänge (EIAJ-Norm) erreicht. Höhere Anschlußzahlen lassen sich nur durch kostspielige Sondergehäuseformen erzielen. Diese Sondergehäuse, sogenannte Arrays, haben aber den Nachteil, daß sie nicht zu den modernen nicht durchkontaktierenden Bestückungs-und Lötverfahren passen.

Ein bekanntes Verfahren zur Herstellung sehr kleiner Anschlußraster beruht auf der Verwendung eines Filmträgermaterials (z. B. Polyimid), auf dem im Positiv- oder Negativverfahren ein Anschlußraster erzeugt wird, das in der Montage direkt in Löttechnik mit dem Chip verbunden ist. Die hierfür erforderliche Lötmenge wird vom Chip ausgehend in mehreren Zusatzprozessen aufgebracht. Mit diesem "Tape Automated Bonding" können Anschlußbreiten von 50 μ mit einem Abstand von 30 μ , also ein Raster von 80 μ , verwirklicht werden. Dieses Verfahren ist jedoch relativ teuer und unflexibel. Es entstehen hohe Filmmaterial- und Werkzeugkosten, die bei jeder Änderung im Chipdesign neu aufgebracht werden müssen. Eine rationelle Fertigung von kleineren Stückzahlen ist daher nicht möglich. Ferner erfordern diese Produkte spezielle Bestückungstechniken beim Kunden.

Der Erfindung liegt demgegenüber die Aufgabe zugrunde, einen Anschlußrahmen der eingangs erwähnten Art preiswert herstellbar zu machen, der eine hohe Anschlußzahl ermöglicht.

Diese Aufgabe wird erfindungsgemäß bei einem Anschlußrahmen der eingangs erwähnten Art dadurch gelöst, daß die metallischen Leiter im äußeren Bereich im herkömmlichen Fertigungsverfahren und an ihrem zu den Anschlüssen zeigenden Enden durch Laserschneiden von einheitlich metallischem Material hergestellt sind.

Erfindungsgemäß wird zur Herstellung der Leiter des Anschlußrahmens erstmalig eine Kombination von mehreren Herstellungsverfahren vorgenommen. Die Erfindung beruht auf der Erkenntnis, daß die herkömmlichen Verfahren für die größeren Abstände im äußeren Bereich der Anschlußrahmen ausreichend sind, so daß das für jeden Anwendungsfall günstigste, meistens preisgünstigste, Verfahren ausgewählt wird. Die Begrenzung der Anschlußdichte ist durch die Nachteile der herkömmlichen Verfahren bedingt, die eine Verkleinerung des Abstandes zwischen den Anschlußenden der Leiter nicht erlauben. Erfindungsgemäß wird am inneren Ende der Leiterbahn ein Laserschneidverfahren eingesetzt, so daß nach der Anwendung des herkömmlichen Verfahrens auf die äußeren Enden der Leiter innen eine einheitliche metallische Fläche verbleibt, die dann durch Laserschneiden in die gewünschten Verlängerungen der hergestellten Leiter unterteilt wird. Das Laserschneiden ist sehr flexibel, erfordert jedoch relativ viel Zeit. Der erforderliche Zeitaufwand ist jedoch für die Herstellung des erfindungsgemäßen Anschlußrahmens unkritisch, weil nur die kleinen Abschnitte am inneren Ende der Leiter durch das Laserschneiden hergestellt werden, während regelmäßig die größte Länge der Leiter durch die herkömmlichen, schnellen Verfahren, wie Stanzen oder Ätzen, produziert werden.

Die Erfindung soll im folgenden anhand der beigefügten Zeichnung näher erläutert werden. Es zeigen:

Figur 1 - Leiter eines erfindungsgemäßen Anschlußrahmens, die vor einem Anschlußfeld enden,

Figur 2 - die Leiter gemäß Figur 1, die mit Bonddrähtchen mit Anschlußflächen eines Halbleiterchips verbunden sind.

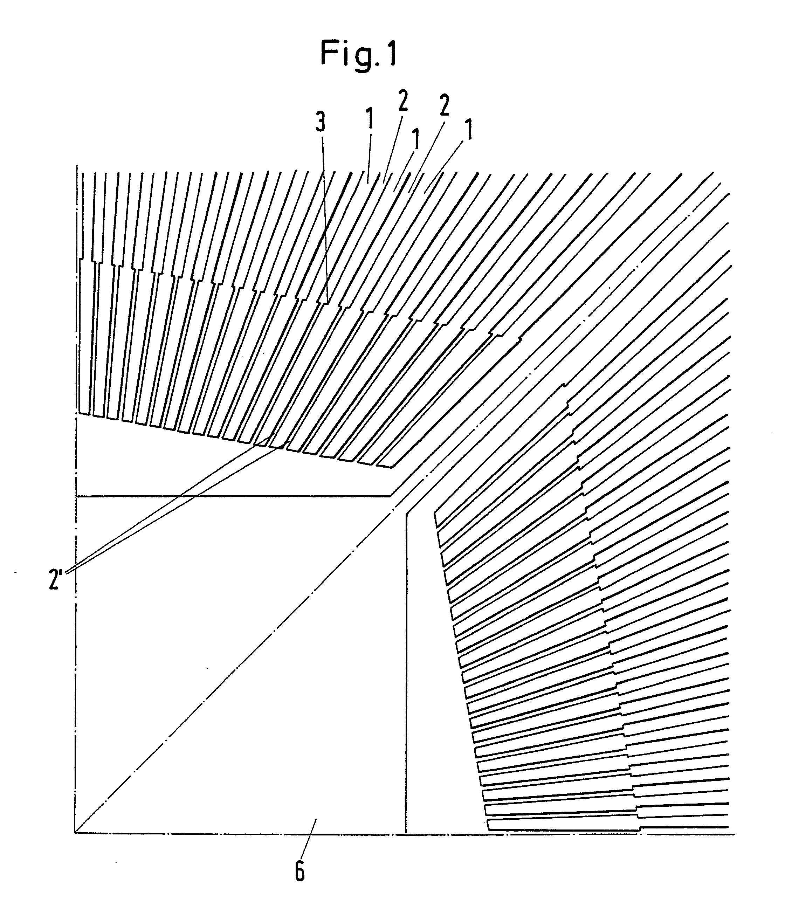

Figur 1 läßt eine Vielzahl von etwa sternförmigen Leitern 1 erkennen, die im äußeren Bereich des Anschlußrahmens relativ breit sind und durch ebenfalls relativ breite Zwischenräume 2 voneinander getrennt sind. Die Leiter 1 lassen sich an ihren äußeren Enden in herkömmlicher Technik kontaktieren.

Über einen großen Bereich ihrer Länge sind die Leiter 1 in herkömmlicher Technik, beispielsweise durch Ätzen oder Stanzen, hergestellt. Wo aufgrund des konvergierenden Verlaufs der Leiter 1 die Breite der Leiterbahn aufgrund des einzuhaltenden Minimal-Abstands 2 an die untere vertretbare Grenze gelangt, ist eine Stufe 3 in der Leiterbahn 1 ausgebildet, durch die die Leiterbahnen wieder verbreitert und durch sehr schmale Abstände 2' konstanter Breite getrennt sind. Die Abstände 2' konstanter Breite sind durch Laserschneiden des innerhalb der Stufe 3 ursprünglich einheitlich ausgebildeten metallischen Materials hergestellt. Durch das Laserschneiden können sehr geringe Breiten der Abstände 2' realisiert werden, so daß der Rasterabstand der Leiter 1 am inneren Ende des Anschlußrahmens etwa dem Rastermaß von Anschlußfeldern 4 eines Halbleiterchips 5 entspricht oder nur wenig größer ist.

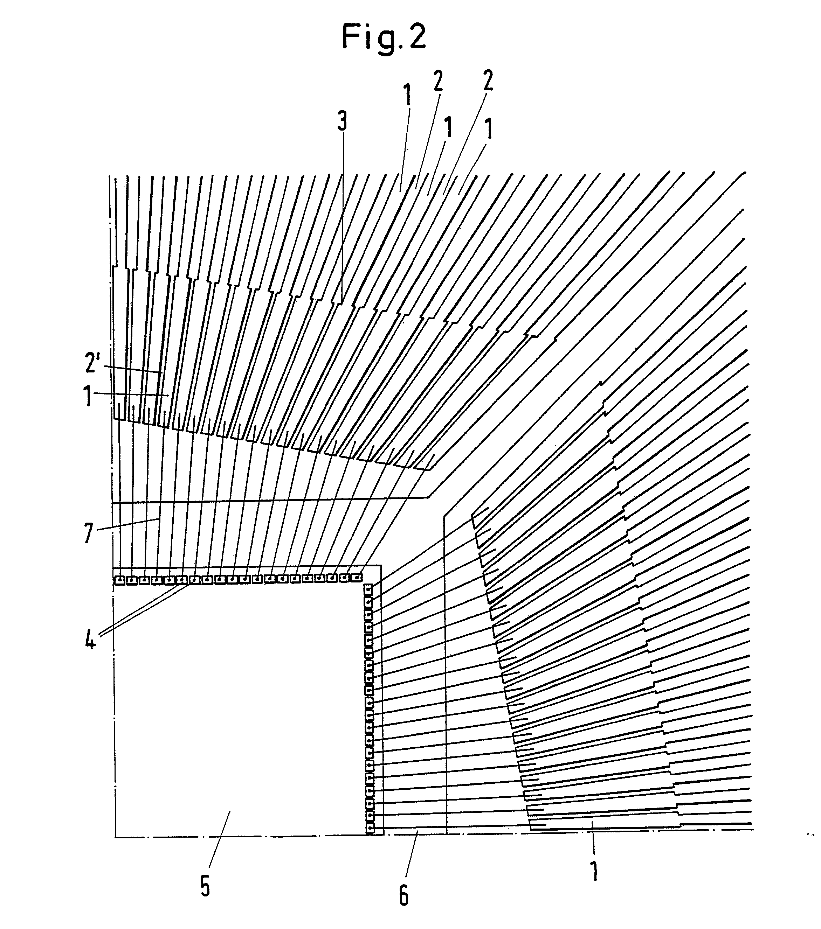

Figur 2 zeigt ein Halbleiterchip 5, der auf ein Anschlußfeld 6 innerhalb des Anschlußrahmens positioniert ist. Die Verbindung von den einzelnen Anschlußfeldern 4 zu den metallischen Leitern 1 erfolgt durch übliche Bonddrähte 7.

Aufgrund des am inneren Ende der Leiter entstehenden geringen Rasterabstands durch die geringe Breite der Abstände 2' können die Leiter 1 sehr dicht an das Anschlußfeld 6 herangeführt werden, so daß eine hohe Anschlußbelegung bei kurzem Bonddrähten realisierbar ist.

**Ansprüche**

1. Anschlußrahmen für eine Vielzahl von auf engstem Raum angeordneten Anschlüssen (4), insbesondere von hochintegrierten Halbleiterchips (5), bestehend aus metallischen Leitern (1), die von äußeren großen Abständen (2) zu den Anschlüssen (4) hin aufeinander zulaufen und mit den Anschlüssen verbindbar sind, wobei die metallischen Leiter (1) im äußeren Bereich im herkömmlichen Fertigungsverfahren und an ihren zu den Anschlüssen (4) zeigenden Enden durch Laserschneiden von einheitlich metallischem Material hergestellt sind.

2. Anschlußrahmen nach Anspruch 1, bei der die metallischen Leiter (1) über den größten Teil ihrer Länge im herkömmlichen Fertigungsverfahren hergestellt sind.

# Fig.1

# Fig.2